# EUROPÄISCHE PATENTSCHRIFT

(11) **EP 1 771 799 B1**
(45) Veröffentlichungstag und Bekanntmachung des Hinweises auf die Patenterteilung: **17.12.2008**
(21) Anmeldenummer: 05771429.7
(22) Anmeldetag: 28.07.2005
(51) Int. Cl.: G06F 17/50

(54) **VERFAHREN ZUR BEWERTUNG DER GÜTE EINES TESTPROGRAMMS**
METHOD FOR EVALUATING THE QUALITY OF A TEST PROGRAM
PROCEDE D'EVALUATION DE LA QUALITE D'UN PROGRAMME D'ESSAI

(30) Priorität: 30.07.2004 DE 102004037402
(43) Veröffentlichungstag der Anmeldung: 11.04.2007
(73) Patentinhaber: Certess S.A., 38340 Voreppe (FR)
(72) Erfinder: GROSSE, Jörg, 01099 Dresden (DE); HAMPTON, Mark, 38260 La Côte-Saint-André (FR)
(74) Vertreter: Carlsohn, Alexander
(86) Internationale Anmeldenummer: PCT/DE2005/001349
(87) Internationale Veröffentlichungsnummer: WO 2006/012875

(56) Entgegenhaltungen:
- DE-A1- 19 959 157
- JEFFERSON OFFUTT A: "INVESTIGATIONS OF THE SOFTWARE TESTING COUPLING EFFECT" ACM TRANSACTIONS ON SOFTWARE ENGINEERING AND METHODOLOGY, ASSOCIATION FOR COMPUTING MACHINERY, NEW YORK, US, Bd. 1, Nr. 1, Januar 1992 (1992-01), Seiten 5-20, XP000365048 ISSN: 1049-331X
- KING K N ET AL: "A FORTRAN LANGUAGE SYSTEM FOR MUTATIONBASED SOFTWARE TESTING*" SOFTWARE PRACTICE & EXPERIENCE, WILEY & SONS, BOGNOR REGIS, GB, Bd. 21, Nr. 7, 1. Juli 1991 (1991-07-01), Seiten 685-718, XP000297324 ISSN: 0038-0644
- VADO P ET AL: "A methodology for validating digital circuits with mutation testing" CIRCUITS AND SYSTEMS, 2000. PROCEEDINGS. ISCAS 2000 GENEVA. THE 2000 IEEE INTERNATIONAL SYMPOSIUM ON MAY 28-31, 2000, PISCATAWAY, NJ, USA,IEEE, Bd. 1, Mai 2000 (2000-05), Seiten I343-I346, XP010503205 ISBN: 0-7803-5482-6

## Beschreibung

Die Erfindung betrifft ein Verfahren zur Bewertung der Güte eines Testprogramms für mittels eines Computers simulierte integrierte Schaltungen.

Die Größe und Komplexität von integrierten Schaltungen nimmt ständig zu. Damit ist jedoch auch die Zunahme von Fehlern verbunden.

In der Regel werden integrierte Schaltungen mittels spezieller Computersprachen, sogenannten High Level Description Languages (HDLs), beschrieben. Übliche HDLs sind VHDL und Verilog. Der HDL-File wird verwendet, um mittels spezieller Computerprogramme automatisch das Layout der Schaltungsanordnung und die erforderlichen photolithographischen Masken zu erzeugen, mit denen die tatsächliche Schaltungsanordnung hergestellt werden kann.

Zur Vermeidung von Fehlern in den integrierten Schaltungen kann es jedoch erforderlich sein, die mittels des HDL-Files beschriebenen Schaltungsanordnungen zu testen. Zu diesem Zwecke werden Programme verwendet, die auf Grundlage des HDL-Files die integrierte Schaltung simulieren. Derartige Programme werden als Simulatoren bezeichnet. Ein solcher Simulator wirkt mit einer als Prüfbank ("Test-Bench") bezeichneten Einheit, dem Testprogramm (d. h. Computercode) zusammen, das die Eingangswerte ("Input") bereitstellt, die die integrierte Schaltung verarbeiten soll, und die Ergebnisse der Verarbeitung (Ausgangswerte) in der simulierten Schaltung mit den erwarteten Ergebnissen vergleicht. Das Testprogramm beschreibt also (1) die Eingangswerte (ggf. im Form von Signalwellenformen), (2) die Leistungs- und Richtigkeitskriterien, die nach der Verarbeitung der Eingangswerte in der simulierten Schaltung erhalten werden, und (3) die Handlungen, die der Simulator ausführen soll, wenn die Ergebnisse der Simulation den Leistungs- und Richtigkeitskriterien entsprechen oder wenn dies nicht der Fall ist.

Das Testergebnis hängt allerdings wesentlich von der Qualität und der Vollständigkeit des Testprogramms ab. Im Hinblick auf die hohe Zahl elektronischer Komponenten, die in dem HDL-File beschrieben werden, ist es sehr schwierig, Prüfbanken zu schaffen, die der Komplexität der zu testenden simulierten integrierten Schaltung gerecht werden. Fehler in der simulierten Schaltung können nur dann gefunden werden, wenn das Testprogramm tatsächlich Tests vorsieht, die den fehlerhaften Bereich der simulierten integrierten Schaltung betreffen. Anderenfalls kann ein positives Testergebnis unter Umständen lediglich auf eine unzureichende Testung (bzw. Verifizierung) der integrierten Schaltung zurückzuführen sein. Eine Überprüfung der Qualität und der Vollständigkeit des Testprogramms ist daher erforderlich. Die ohnehin geringe Geschwindigkeit der Softwaresimulation einer integrierten Schaltung wird durch Tests, die die Qualität und die Vollständigkeit des Testprogramms überprüfen sollen, allerdings weiter verringert.

DE 199 59 157 A1 beschreibt ein Verfahren zum funktionsmäßigen Simulieren und Überprüfen der Korrektheit eines Computerprogramms, bei dem mutationsbehaftete Computerprogramme erzeugt werden. Das Computerprogramm kann Quellcodemodule aus Funktionsmodellen einer integrierten Schaltung aufweisen. Das Verfahren simuliert ein Computerprogramm, in das eine syntaktische Mutation eingebaut wurde, um festzustellen, ob diese Mutation im Kontext des Computerprogramms eine feine oder grobe Mutation ist. Ist die Mutation eine grobe Mutation so wird die Simulation beendet; ist die Mutation dagegen eine feine Mutation so wird versucht, diese Mutation innerhalb eines vorbestimmten Zeitraums zu erfassen. Das Verfahren bewertet somit die Güte eines Computerprogramms, indem es versucht, den Einfluß der Mutation im Kontext des Computerprogramms zu bestimmen. Das offenbarte System vergleicht dazu das mutationsbehaftete Computerprogramm mit dem nicht mutierten Computerprogramm. Es ist daher nur zur Bestimmung der Güte der Stimulation der Mutationen durch die Testumgebung geeignet. Auf die Güte des eigentlich zu testenden Computerprogramms kann daraus nur indirekt geschlossen werden. Fehler, die bereits in der nicht mutierten Schaltung enthalten sind, können nur dann erkannt werden, wenn die Mutation tatsächlich Auswirkungen auf die Fehler hat. Dies ist jedoch nicht zwingend der Fall. Die Güte des Computerprogramms kann somit mit dem vorgeschlagenen System nur unzureichend bestimmt werden.

Jefferson Offutt, A., beschreibt in "Investigations of the Software Testing Coupling Effect", ACM Transactions on Sogtware Engineering and Methodology, Bd. 1, Nr. 1, Jan. 1992, S. 5-20, daß eine lebende Mutante zerstört wird, sobald sie Ausgangswerte liefert, die inkorrekt sind.

Aufgabe der Erfindung ist es, die Nachteile nach dem Stand der Technik zu beseitigen. Insbesondere soll ein Verfahren angegeben werden, daß die Bewertung der Güte eines Testprogramms für mittels eines Computers simulierte integrierte Schaltungen mit höherer Qualität ermöglicht.

Diese Aufgabe wird durch die Merkmale des Anspruchs 1 gelöst. Zweckmäßige Ausgestaltungen der Erfindungen ergeben sich aus den Merkmalen der Ansprüche 2 bis 15.

Nach Maßgabe der Erfindung ist ein Verfahren zur Bewertung der Güte eines Testprogramms für mittels eines Computers simulierte integrierte Schaltungen gemäß dem anhängenden Patentanspruch 1 vorgesehen.

Das erfindungsgemäße Verfahren vergleicht somit die von der mutierten integrierten Schaltung genierten Ausgangswerte mit Erwartungswerten, die aus einer unabhängigen Quelle, d. h. dem Referenzsystem stammen. Die Erwartungswerte sollen in einem Referenzsystem generiert werden, das unabhängig von der in der ersten Datei beschriebenen integrierten Schaltung ist. Unter "unabhängig" wird dabei verstanden, daß das Referenzsystem nicht auf der ersten Datei basiert, sondern funktionelle Unterschiede gegenüber der integrierten Schaltung, die in der ersten Datei beschrieben wird, aufweist. Vorteilhafterweise kann das Referenzsystem in einer anderen Programmiersprache und/oder durch einen zweiten Programmierer programmiert sein.

In einer ersten Ausführungsform umfaßt Schritt (b) folgende Schritte:
(b1) das Erzeugen einer zweiten Datei, die die mutierte integrierte Schaltung beschreibt, aus der ersten Datei durch den Einbau der Mutationen in die erste Datei; und
(b2) das Simulieren der mutierten integrierten Schaltung.

Alternativ kann Schritt (b) in einer zweiten Ausführungsform folgende Schritte umfassen:
(b1) das Einlesen der ersten Datei in das Simulationsprogramm des Computers;
(b2) das Abbilden der in der ersten Datei beschriebenen integrierten Schaltung in dem Simulationsprogramm;
(b3) den Einbau der Mutationen in die in dem Simulationsprogramm abgebildete integrierte Schaltung, wodurch die mutierte integrierte Schaltung erhalten wird; und
(b4) das Simulieren der mutierten integrierten Schaltung.

Die erste Datei kann aus einer Vielzahl von Unterdateien bestehen, die dann zusammen die integrierte mutierte Schaltung beschreiben.

Das Simulationsprogramm des Computers ist der Teil des Computers, indem die Simulation der mutierten integrierten Schaltung durchgeführt wird.

Der Einbau der Mutationen in die integrierte Schaltung umfaßt in beiden Ausführungsformen zweckmäßigerweise folgende Schritte:
(i) Analyse der ersten Datei, um die Stellen in der ersten Datei aufzufinden, an denen Mutationen eingebaut werden können, und für jede aufgefundene Stelle den Typ der Mutation zu bestimmen, der an dieser Stelle eine Änderung des Verhaltens der integrierten Schaltung bewirkt;
(ii) Analyse der Tests, die das Testprogramm ausführen kann, um die Tests auszuwählen, die Eingangswerte bereitstellen, die eine Mutation ansprechen können; und
(iii) Auswahl der Mutationen, die an einer gemäß Schritt (i) aufgefundenen Stelle eine Änderung des Verhaltens der integrierten Schaltung bewirken und die durch einen der Tests angesprochen werden können, und Erzeugen der mutierten integrierten Schaltung.

Unter dem Ausdruck "eine Mutation ansprechen" ist im Sinne der vorliegenden Erfindung zu verstehen, daß eine aktiv geschaltete Mutation an der Verarbeitung der Eingangswerte beteiligt und an der Generierung der Ausgangswerte mitwirken kann. Ob sie tatsächlich beteiligt ist oder mitwirkt, d. h. eine Veränderung der Ausgangswerte bewirkt, wird durch den Vergleich der Ausgangswerte mit den Erwartungswerten überprüft.

Unter einer aktivierten, aktiven oder aktiv geschalteten Mutation ist folgendes zu verstehen: Erfindungsgemäß weist die mutierte integrierte Schaltung Mutationen gegenüber der in der ersten Datei beschriebenen integrierten Schaltung auf. Diese Mutationen sind zunächst inaktiviert, d. h. die in der ersten Datei beschriebene integrierte Schaltung liefert genau dieselben Ausgangswerte wie die mutierte integrierte Schaltung, da keine der Mutationen an der Verarbeitung der Eingangswerte teilnimmt. Im Lauf des Verfahrens wird jedoch nacheinander immer genau eine der eingebauten Mutationen aktiv geschaltet, d. h. die aktiv geschaltete Mutation kann an der Verarbeitung der Eingangswerte teilnehmen. Dabei wurden die Tests, die die Eingangswerte liefern, so ausgewählt, daß sie der aktiv geschaltete Mutation ansprechen.

Tests, die eine der ausgewählten Mutationen zumindest einmal ansprechen können, werden zweckmäßigerweise zu einem Testset zusammengefaßt. Tests, die eine ausgewählte Mutation zumindest einmal ansprechen können, werden im folgenden auch als dieser Mutation zugeordnete Tests bezeichnet. Testsets, die diese Tests umfassen, werden auch als dieser Mutation zugeordnete Testsets bezeichnet.

Unter einer Mutation wird im Sinne der vorliegenden Erfindung eine Veränderung der ersten Datei verstanden, die eine funktionelle Veränderung der elektronischen Schaltung, die auf Basis dieser Datei generiert wird, bewirkt. Die Mutation kann in einer Anweisung, die in der Datei beschrieben ist, positioniert werden oder über mehrere Testzeilen der Datei verteilt sein. Im Sinne der vorliegenden Erfindung sind Mutationen funktionelle Mutationen, die in die RTL-Ebene (RTL = Register Transfer Level) oder eine höhere Ebene (Systemebene oder algorithmische Ebene) der integrierten Schaltung eingebaut werden. Im folgenden ist unter einer Mutation eine funktionelle Mutation zu verstehen, sofern nichts anderes angegeben ist.

Geeignete Mutationstypen sind beispielsweise logische Negationsfehler, Auslassen logischer Faktoren, unkorrekte logische Faktoren, Auslassungen von logischen Ausdrücken, unkorrekte logische Ausdrücke, unkorrekte numerische Werte und Fallauslassungen. Die Mutationen im Sinne der vorliegenden Erfindung sind willentliche Veränderungen. Mutationen, die in der ersten Datei bereits enthalten sind, stellen Änderungen gegenüber dem vom Programmierer tatsächlich beabsichtigten Programmierziel, das in der Datei abgebildet wird, dar. Solche nicht-willentlichen Mutationen sollen in Tests, während denen die in der ersten Datei beschriebene integrierte Schaltung simuliert wird, erkannt werden. Dies kann jedoch nur dann mit hinreichendem Erfolg der Fall sein, wenn das Testprogramm eine ausreichende Güte aufweist, d. h. die nicht-willentlichen Mutationen tatsächlich von dem Testprogramm erkannt werden können. Diese Fähigkeit, d. h. die Fähigkeit des Testprogramms, Mutationen zu erkennen, wird durch den willentlichen Einbau von Mutationen in die erste Datei und Simulieren der erhaltenen mutierten integrierten Schaltung überprüft. Erkennt das Testprogramm die willentlich eingebauten Mutationen nicht, so ist nicht zu erwarten, daß es nicht-willentlich eingebaute Mutationen erkennen kann, da das Testprogramm in diesem Fall keine Tests ausführt, die Mutationen dieses Typs an der Stelle, an der die Mutation willentlich eingebaut worden ist, auffinden könnten. Das erfindungsgemäße Verfahren, das es ermöglicht, zunächst das Testprogramm auf seine Eignung zu testen, die integrierte Schaltung zu testen, die in der ersten Datei beschrieben wird, stellt somit eine erhebliche qualitative Verbesserung gegenüber den bisherigen Testverfahren für integrierte Schaltungen dar, da das Testergebnis, das beim Testen der ersten Datei durch Simulation der darin beschriebenen integrierten Schaltung erhalten wird, entscheidend von der Güte des Testprogramms abhängt. Ist die Güte des Testprogramms gering (dies ist der Fall, wenn es keine oder keine hinreichende Zahl von Tests bereitstellt, die die in der (ersten) Datei enthaltenen nicht-willentlichen Mutationen auffinden können), so wird bei Ausführung dieses Testprogramms ein positives Testergebnis erhalten, das den Tatsachen aufgrund der Mängel des Testprogramms nicht entspricht. Die aufgrund dieses Testergebnisses hergestellte integrierte Schaltung ist tatsächlich nicht hinreichend getestet worden und kann erhebliche Fehler, die aus den nicht-willentlichen Mutationen resultieren, aufweisen. Demgegenüber bietet das erfindungsgemäße Verfahren aufgrund der Überprüfung des Testprogramms eine hohe Gewähr dafür, daß die integrierte Schaltung tatsächlich hinreichend überprüft worden ist, da Testprogramme mit geringer Güte, d. h. Testprogramme, die keine oder keine hinreichende Zahl von Tests bereitstellen, die die in der (ersten) Datei enthaltenen nicht-willentlichen Mutationen auffinden können, zum Testen der ersten Datei nicht eingesetzt werden oder so verändert werden, daß sie Tests bereitstellen, die die nicht-willentlichen Mutationen auffinden können.

Im folgenden wird unter einer Mutation eine willentliche Mutation verstanden.

Die Güte des Testprogramms wird, wie bereits erläutert, durch den Vergleich der generierten Ausgangswerte, die von der simulierten integrierten Schaltung generiert werden, mit den Erwartungswerten, die in dem Testprogramm enthalten sind, bestimmt. Das Ergebnis dieses Vergleiches kann als negativ angesehen werden, wenn der für eine Mutation erhaltene Ausgangswert dem für den Ausgangswert vom Referenzsystem generierten Erwartungswert gleicht. In diesem Fall ist die Mutation, die ja eine Veränderung des Ausgangswertes hätte bewirken müssen, von den Tests, die von dem Testprogramm ausgeführt worden sind, nicht erkannt worden.

Im Gegensatz dazu kann das Ergebnis des Vergleiches als positiv angesehen werden, wenn der für eine Mutation erhaltene Ausgangswert ungleich dem für den Ausgangswert vom Referenzsystem erzeugten Erwartungswert ist. In diesem Fall hat die Mutation eine Veränderung des Ausgangswertes bewirkt (oder die Veränderung des Ausgangswertes beruht auf einer nicht-willentlichen Mutation), was zeigt, daß der Test, der von dem Testprogramm ausgeführt wird, für das Testen der simulierten Schaltung nützlich ist, da er eine Veränderung, d.h. die Abweichung der von der simulierten Schaltung genierten Ausgangswerte von den Erwartungswerten, erkennt.

Die Anforderungen, die an die Güte des Testprogramms gestellt werden, hängen natürlich von den Vorgaben ab, die von dem Anwender an die Güte der integrierten Schaltung, die in der ersten Datei beschrieben wird, gestellt werden. In einer bevorzugten Ausführungsform wird die Güte des Testprogramms aus dem Verhältnis der Anzahl der positiven Vergleichsergebnisse zur Anzahl der negativen Vergleichsergebnisse ermittelt. Dann kann die Güte des Testprogramms mit gut bewertet werden, wenn für jede eingebaute Mutation ein positives Vergleichsergebnis erhalten wird. Alternativ kann die Güte des Testprogramms mit gut bewertet werden, wenn die Anzahl der Mutationen, für die ein positives Vergleichsergebnis erhalten wird, einen vorgegebenen Wert übersteigt.

Ist das Ergebnis des Vergleiches für eine Mutation negativ, so kann das Verfahren nach einer der folgenden Alternativen fortgeführt werden:
Variante 1: Der Erwartungswert für diese Mutation wird verändert und anschließend die Schritte (b) bis (e) wiederholt werden. Dies ist insbesondere dann sinnvoll, wenn zweifelhaft ist, ob die Erwartungswerte, die von dem Referenzsystem geliefert werden, tatsächlich den vom Programmier der ersten Datei beabsichtigten Ausgangswerten entsprechen.
Variante 2: Die erste Datei wird verändert, und anschließend werden die Schritte (b) bis (e) wiederholt. Dies ist insbesondere dann sinnvoll, wenn das negative Ergebnis möglicherweise auf nicht-willentliche Mutationen in der ersten Datei zurückzuführen ist, die die willentlichen Mutationen derart beeinflussen, daß die von letzteren bewirkten Veränderungen sich nicht auf die Ausgangswerte auswirken.
Variante 3: Es werden Tests ausgewählt, die dieser Mutation ansprechen und gegenüber den bisherigen Tests veränderte Eingangswerte bereitstellen, und anschließend die Schritte (b) bis (e) wiederholt. Dies ist insbesondere dann sinnvoll, wenn vermutet werden kann, daß weder dem Referenzsystem noch der simulierten integrierten Schaltung Eingangswerte zugeführt worden sind, die zu Erwartungswerten bzw. Ausgangswerten führten, die im Hinblick auf den beabsichtigten Verwendungszweck der integrierten Schaltung sinnvoll sind.

Die mutierte integrierte Schaltung kann mittels eines Hardwarebeschleunigers realisiert werden. Eine bevorzugter Hardwarebeschleuniger ist eine feldprogrammierbare Gateanordnung (FPGA).

Die Erfindung wird nachstehend anhand von Zeichnungen näher erläutert. Dabei zeigt
- Fig. 1: ein Flußdiagramm zur Veranschaulichung einer ersten Ausführungsform des erfindungsgemäßen Verfahrens;
- Fig. 2: die erste Datei in Form eines HDL-Files einer beispielhaften unmutierten integrierten Schaltung; und
- Fig. 3: die aus der ersten Datei erhaltene zweite Datei in Form eines HDL-Files einer mutierten integrierten Schaltung.
- Fig. 4: ein Flußdiagramm zur Veranschaulichung einer zweiten Ausführungsform des erfindungsgemäßen Verfahrens; und
- Fig. 5: eine schematische Darstellung des der Erfindung zugrundeliegenden Prinzips.

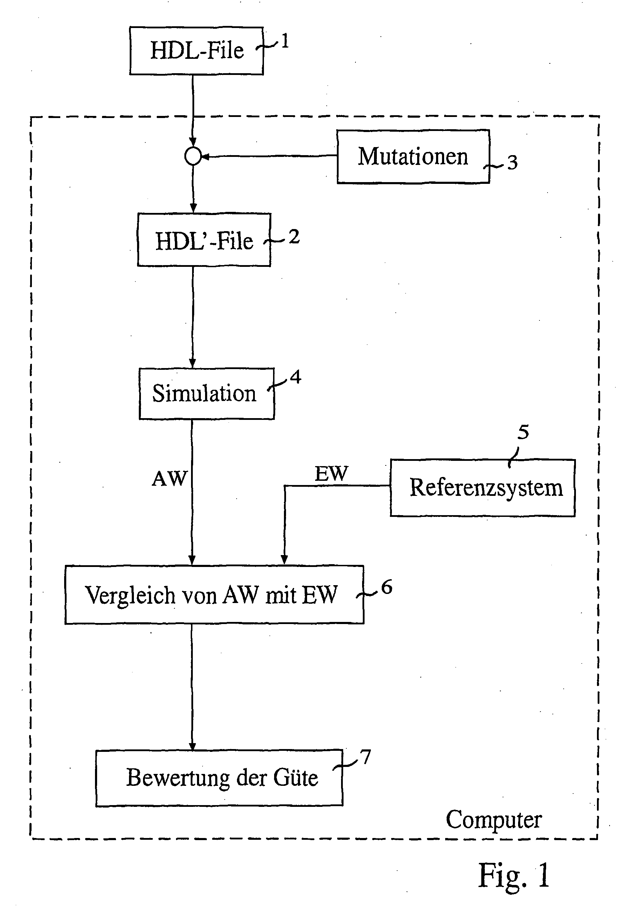

Nach Fig. 1, die eine erste Ausführungsform des erfindungsgemäßen Verfahrens zeigt, ist die erste Datei ein HDL-File 1. Der HDL-File 1 beschreibt eine integrierte Schaltung, die nicht-willentliche Mutationen enthalten kann. Die erste Datei wird in den Computer, der durch eine gestrichelte Linie dargestellt ist, überführt. In dem Computer wird aus dem HDL-File 1 ein mutierter HDL-File erzeugt, der die zweite Datei darstellt und als HDL'-File 2 bezeichnet ist. Dazu werden funktionelle Mutationen 3, die von dem Testprogramm bereitgestellt werden, in der beschriebenen Weise in den HDL-File 1 eingebaut. Der erhaltene HDL'-File 2 beschreibt eine mutierte integrierte Schaltung, die auf der in dem HDL-File 1 beschriebenen integrierten Schaltung basiert, jedoch zusätzlich Mutationen aufweist.

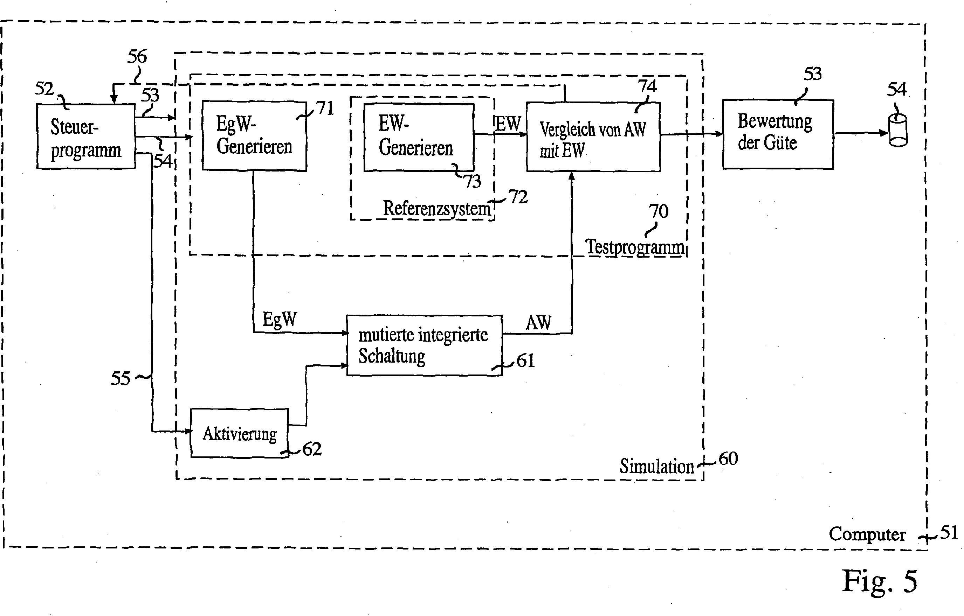

Die im HDL'-File 2 beschriebene mutierte integrierte Schaltung wird von dem Simulationsprogramm simuliert. Während der Simulation 4 werden von einem Steuerprogramm 52 (siehe dazu Fig. 5) die eingebauten Mutationen nacheinander und - sofern dies zweckmäßig ist - in einer vorgegebenen Reihenfolge aktiviert, so daß jeweils nur eine Mutation aktiviert ist. Das Testprogramm 70 führt die Tests aus, die die jeweils aktivierte Mutation ansprechen können. Dieses Tests sind in Testsets zusammengefaßt. Das Testprogramm 70 generiert in Abhängigkeit von dem ausgewählten Test Eingangswerte EgW, die der simulierten mutierten integrierten Schaltung 61 zugeführt werden. Diese Eingangswerte EgW werden von der simulierten mutierten integrierten Schaltung 61 verarbeitet und dabei in Ausgangswerte AW überführt. Die Ausgangswerte AW werden dann von dem Testprogramm 70 mit Erwartungswerten EW verglichen (Bezugszeichen 6 in Fig. 1), die von dem Testprogramm 70 mittels eines Referenzsystems 5 (in Fig. 5 Bezugszeichen 72) generiert werden. Die in dem Testset zusammengefaßten Tests werden solange nacheinander ausgeführt, bis ein Test zu Ausgangswerten AW führt, die sich von den Erwartungswerten EW unterscheiden. Anschließend wird die aktivierte Mutation inaktiv geschaltet und - sofern noch nicht alle eingebauten Mutationen getestet worden sind - die nächste Mutation aktiviert, der wiederum ein Testset mit Tests, die diese nun aktivierte Mutation ansprechen, zugeordnet ist.

Es ist somit nicht erforderlich, alle Tests, die in einem Testset zusammengefaßt sind, auszuführen. Die Ausführung der Tests eines Testsets für eine Mutation kann abgebrochen werden, sobald die Ausgangswerte, die bei der Ausführung eines Tests erhalten werden, sich von den Erwartungswerten unterscheiden. Wird festgestellt, daß ein Test in einem Testset die zugehörige Mutation tatsächlich anspricht (was sich in der fehlenden Übereinstimmung der Ausgangswerte mit den Erwartungswerten widerspiegelt), so kann aus dieser Feststellung gefolgert werden, daß das Testprogramm zumindest einen Test bereitstellt, der die zugehörige Mutation testen kann. Dieser Fall ist ein positives Testergebnis, da das Testprogramm die Mutation erkennt. Die Güte des Testprogramms ist somit in bezug auf die eine Mutation gut. Werden für keinen Test des Testsets Ausgangswerte erhalten, die sich von den Erwartungswerten unterscheiden, so hat die aktive Mutation keinen Einfluß auf die Verarbeitung der Eingangswerte zu Ausgangswerten gehabt. Dieser Fall ist ein negatives Testergebnis, da das Testprogramm die Mutation nicht erkennt. Die Güte des Testprogramms ist somit in bezug auf die eine Mutation schlecht.

Aus der Anzahl der auf diese Weise vom Testprogramm erkannten Mutationen kann die Güte des Testprogramms ermittelt werden (Bezugszeichen 7 in Fig. 1). Wird jede Mutation erkannt, so ist die Güte des Testprogramms gut. Werden nicht alle Mutationen erkannt, so ist dieses Ergebnis ein schlechteres Ergebnis, wobei allerdings aus dem Verhältnis der erkannten Mutationen zu den nicht erkannten Mutationen ein Wert für die Güte berechnet werden kann, der wiederum mit einem vorgegebenen Wert verglichen wird. Ist der berechnete Wert für die Güte höher als der vorgegebene Wert, so kann das Testprogramm als gut bewertet werden.

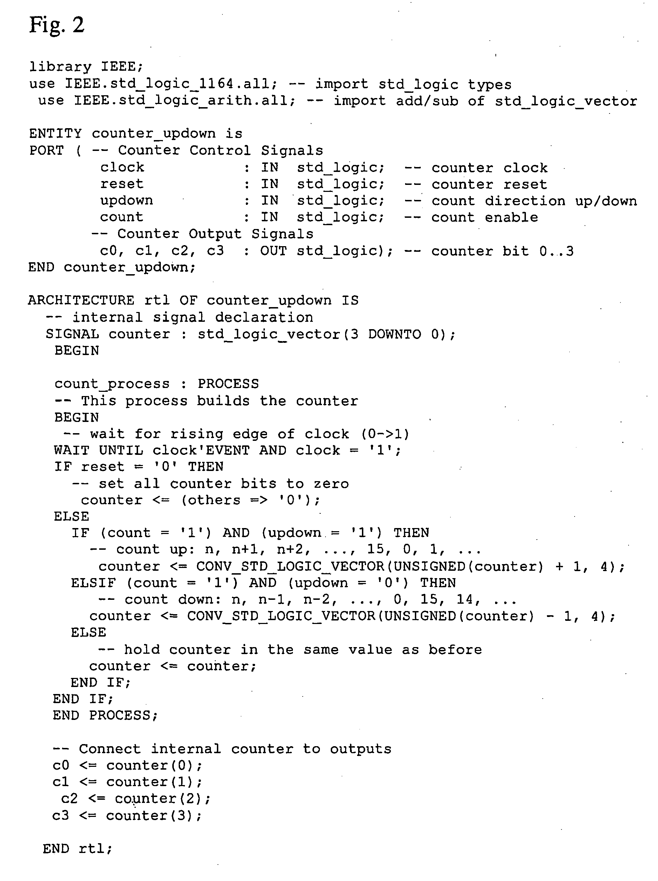

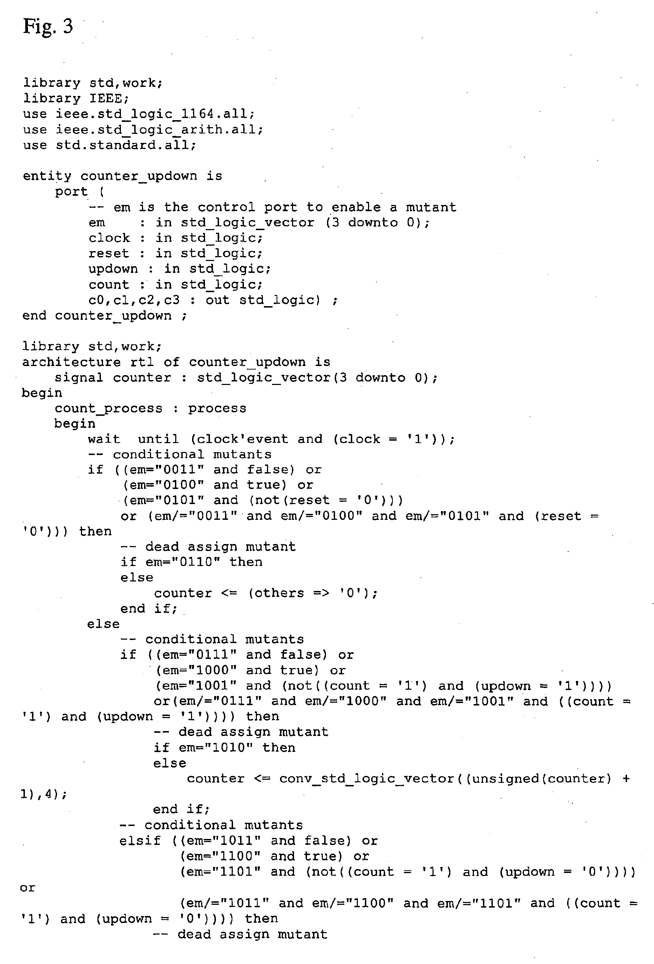

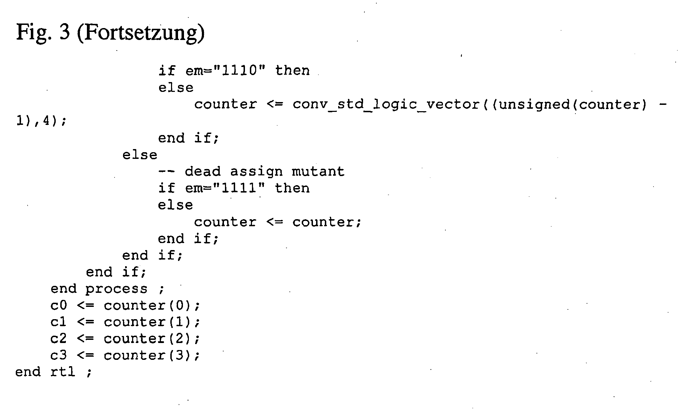

In Fig. 2 wird ein Beispiel einer ersten Datei in Form eines HDL-File 1 gezeigt, aus dem, wie in Fig. 3 gezeigt wird, ein mutierter HDL'-File 2 erhalten wurde, indem Mutationen in den HDL'-File 1 eingebaut worden sind.

Der in Fig. 2 dargestellte HDL-File enthält den vollständigen HDL-Code für einen 4-Bit-Vorwärts/Rückwärts-Zähler, der die Datenausgänge C0, C1, C2 und C3 aufweist und von 0 bis 15 oder in entgegengesetzter Richtung zählt. Er umfaßt folgende Dateneingänge:
Reset: der Zähler wird bei Reset = 0 auf den Wert 0 zurückgesetzt, wenn eine steigende Clock-Flanke vor-liegt (d. h. Clock von 0 auf 1 geht);
Clock: Takteingang - steigende Flanke (auch als "Clock-Flanke" bezeichnet)
UpDown: der Zähler addiert bei UpDown = 1; er subtrahiert bei UpDown = 0
Count: der Wert des Zählers wird mit der steigenden Clock-Flanke um eins erhöht, wenn Count = 1, Reset = 1 und UpDown = 1; der Wert des Zählers wird mit der steigenden Clock-Flanke um eins verringert, wenn Count = 1, Reset = 1 und UpDown = 0; der Wert des Zählers wird nicht verändert, wenn Count = 0 und Reset = 1.

Der in Fig. 3 dargestellte HDL'-File enthält funktionelle Mutationen, die in den in Fig. 2 dargestellten HDL-File eingefügt worden sind. Der HDL'-Code beschreibt einen 4-Bit-Vorwärts/Rückwärts-Zähler, der die Datenausgänge C0, C1, C2 und C3 aufweist und von 0 bis 15 oder in entgegengesetzter Richtung zählt. Er umfaßt folgende Dateneingänge:
Reset: der Zähler wird bei Reset = 0 auf den Wert 0 zurückgesetzt, wenn eine steigende Clock-Flanke vor-liegt (d. h. Clock von 0 auf 1 geht);
Clock: Takteingang - steigende Flanke
UpDown: der Zähler addiert bei UpDown = 1; er subtrahiert bei UpDown = 0
Count: der Wert des Zählers wird mit der steigenden Clock-Flanke um eins erhöht, wenn Count = 1, Reset = 1 und UpDown = 1; der Wert des Zählers wird mit der steigenden Clock-Flanke um eins verringert, wenn Count = 1, Reset = 1 und UpDown = 0; der Wert des Zählers wird nicht verändert, wenn Count = 0 und Reset = 1.

Em ermöglicht es, eine Mutation emi der in den HDL'-File eingefügten Mutationen emn (n 1 bis 13) aktiv zu schalten, während alle anderen Mutationen inak-tiv geschaltet sind.

Die einzelnen Mutationen sind in dem HDL'-File 2 binär als em = "0011" (em1), em = 2"0100" (em2) ... em = "1110" (em13) codiert.

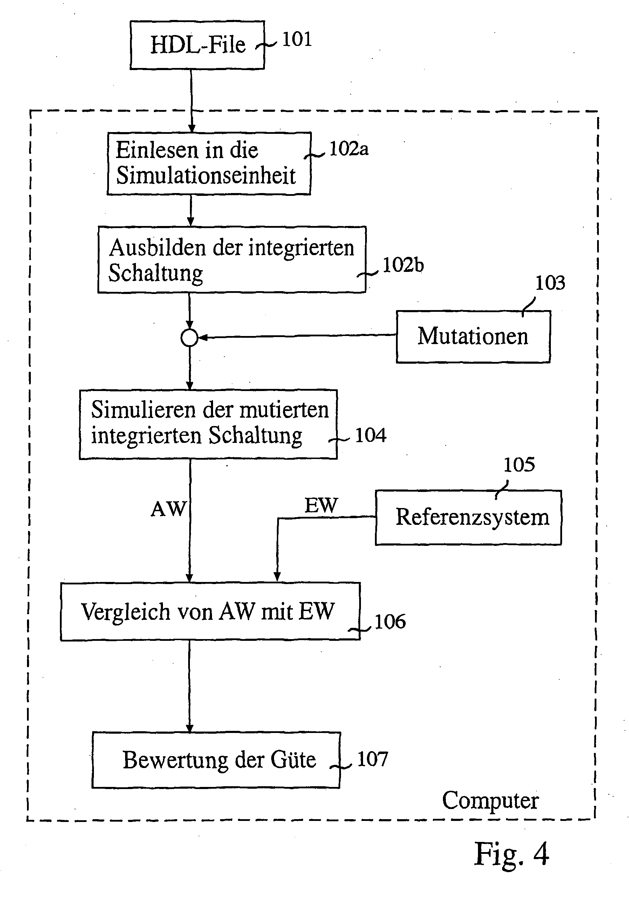

Nach Fig. 4, die eine zweite Ausführungsform des erfindungsgemäßen Verfahrens zeigt, ist die erste Datei ein HDL-File 101. Der HDL-File 101 beschreibt eine integrierte Schaltung, die nicht-willentliche Mutationen enthalten kann. Die erste Datei wird in den Computer, der durch eine gestrichelte Linie dargestellt ist, überführt, in die Simulationseinheit des Computers eingelesen (Bezugszeichen 102a) und dort die integrierte Schaltung abgebildet (Bezugszeichen 102b). Aus der abgebildeten integrierten Schaltung wird eine mutierte integrierte Schaltung erzeugt, indem funktionelle Mutationen 103, die von dem Testprogramm bereitgestellt werden, in der beschriebenen Weise eingebaut werden. Es wird eine mutierte integrierte Schaltung erhalten, die auf der in dem HDL-File 1 beschriebenen integrierten Schaltung basiert, jedoch zusätzlich Mutationen aufweist.

Die mutierte integrierte Schaltung wird von der Simulationseinheit simuliert (Bezugszeichen 104). Während der Simulation 104 werden von einem Steuerprogramm 52 (siehe dazu Fig. 5) die eingebauten Mutationen nacheinander und - sofern dies zweckmäßig ist - in einer vorgegebenen Reihenfolge aktiviert, so daß jeweils nur eine Mutation aktiviert ist. Das Testprogramm führt die Tests aus, die die jeweils aktivierte Mutation ansprechen können. Diese Tests sind in Testsets zusammengefaßt. Das Testprogramm 70 generiert in Abhängigkeit von dem ausgewählten Test Eingangswerte EgW, die der simulierten mutierten integrierten Schaltung 61 zugeführt werden. Diese Eingangswerte EgW werden von der simulierten mutierten integrierten Schaltung 61 verarbeitet und dabei in Ausgangswerte AW überführt. Die Ausgangswerte AW werden dann von dem Testprogramm 70 mit Erwartungswerten EW verglichen (Bezugszeichen 106 in Fig. 4), die von dem Testprogramm mittels eines Referenzsystems 105 (in Fig. 5 Bezugszeichen 72) generiert werden. Die in dem Testset zusammengefaßten Tests werden solange nacheinander ausgeführt, bis ein Test zu Ausgangswerten führt, die sich von den Erwartungswerten unterscheiden. Anschließend wird die aktivierte Mutation inaktiv geschaltet und - sofern noch nicht alle eingebauten Mutationen getestet worden sind - die nächste Mutation aktiviert, der wiederum ein Testset mit Tests, die diese nun aktivierte Mutation ansprechen, zugeordnet ist.

Es ist somit nicht erforderlich, alle Tests, die in einem Testset zusammengefaßt sind, auszuführen. Die Ausführung der Tests eines Testsets für eine Mutation kann abgebrochen werden, sobald die Ausgangswerte, die bei der Ausführung eines Tests erhalten werden, sich von den Erwartungswerten unterscheiden. Wird festgestellt, daß ein Test in einem Testset die zugehörige Mutation tatsächlich anspricht (was sich in der fehlenden Übereinstimmung der Ausgangswerte mit den Erwartungswerten widerspiegelt), so kann aus dieser Feststellung gefolgert werden, daß das Testprogramm zumindest einen Test bereitstellt, der die zugehörige Mutation testen kann.

Dieser Fall ist ein positives Testergebnis, da das Testprogramm die Mutation erkennt. Die Güte des Testprogramms ist somit in bezug auf die eine Mutation gut. Werden für keinen Test des Testsets Ausgangswerte erhalten, die sich von den Erwartungswerten unterscheiden, so hat die aktive Mutation keinen Einfluß auf die Verarbeitung der Eingangswerte zu Ausgangswerten gehabt. Dieser Fall ist ein negatives Testergebnis, da das Testprogramm die Mutation nicht erkennt. Die Güte des Testprogramms ist somit in bezug auf die eine Mutation schlecht.

Aus der Anzahl der auf diese Weise vom Testprogramm erkannten Mutationen kann die Güte des Testprogramms ermittelt werden (Bezugszeichen 107 in Fig. 1). Wird jede Mutation erkannt, so ist die Güte des Testprogramms gut. Werden nicht alle Mutationen erkannt, so ist dieses Ergebnis ein schlechteres Ergebnis, wobei allerdings aus dem Verhältnis der erkannten Mutationen zu den nicht erkannten Mutationen ein Wert für die Güte berechnet werden kann, der wiederum mit einem vorgegebenen Wert verglichen wird. Ist der berechnete Wert für die Güte höher als der vorgegebene Wert, so kann das Testprogramm als gut bewertet werden.

Fig. 5 zeigt in schematischer Darstellung einen Computer 51, der ein Simulationsprogramm (nicht gezeigt), ein Steuerprogramm 52, ein Programm 53 zur Bewertung der Güte des Testprogramms auf Basis der Anzahl der erkannten und der Anzahl der nicht-erkannten Mutationen sowie eine Einrichtung 54 zur Ausgabe des Bewertungsergebnisses umfaßt. Das Simulationsprogramm simuliert die mutierte integrierte Schaltung 61, die gemäß den in Fig. 1 und Fig. 4 dargestellten Ausführungsformen erhalten werden kann. Das Simulationsprogramm führt ferner das Testprogramm 70 aus. Das Ausführen des Testprogramms 70 und die Simulation der mutierten integrierten Schaltung 61 sind als Simulation 60 zusammengefaßt. Das Testprogramm 70 generiert 71 die Eingangswerte EgW für jeden auszuführenden Test und generiert 73 die Erwartungswerte EW mittels eines Referenzsystems 72. Es kann zusätzlich den Vergleich 74 der von der mutierten integrierten Schaltung genierten Ausgangswerte AW ausführen, wobei der Vergleich auch außerhalb des Testprogramms 70 von dem Computer 51 vorgenommen werden kann.

Das Steuerprogramm 52 steuert die Simulation 60 (Pfeil 53) und das Testprogramm 70 (Pfeil 54). Es schaltet ferner die Mutationen, die der mutierte integrierten Schaltung 61 enthalten sind, aktiv und inaktiv (Pfeil 55). Es weist das Testprogramm an, die Tests auszuführen, die der aktiv geschalteten Mutation zugeordnet sind.

Das Testprogramm 70 führt nach den Vorgaben des Steuerprogramms 52 die Tests für die von dem Steuerprogramm 52 aktiv geschalteten Mutationen aus, wozu es die mutierte integrierte Schaltung 61 mit Eingangswerten EgW versorgt. Die von der mutierten integrierten Schaltung 61 für die Eingangswerte EgW erhaltenen Ausgangswerte AW werden dem Testprogramm 70 wiederzugeführt, sofern der Vergleich 74 von dem Testprogramm ausgeführt werden soll und nicht an anderer Stelle von dem Computer 51 durchgeführt wird. Werden die Ausgangswerte AW dem Testprogramm 70 zugeführt, so führt es einen Vergleich 74 zwischen den für die aktiv geschaltete Mutation erhaltenen Ausgangswerten AW und Erwartungswerten EW durch. Anhand der Vergleichsergebnisse wird die Bewertung 53 der Güte des Testprogramms 70 vorgenommen und ein Bericht über ein geeignetes Mittel 54, beispielsweise einen Monitor oder einen Drucker, ausgegeben.

Das Ergebnis des Vergleichs wird ferner dem Steuerprogramm 52 übermittelt, daß, wenn die für eine aktiv geschaltete Mutation erhaltenen Ausgangswerte AW sich von den Erwartungswerten EW unterscheiden, die Ausführung der Tests, die dieser Mutation zugeordnet sind, abbricht, die bisher aktiv geschaltete Mutation inaktiv schaltet und die nächste Mutation aktiv schalten kann (gestrichelter Pfeil 56).

## Patentansprüche

1. Computer-implementiertes Verfahren zur Bewertung der Güte eines Testprogramms für mittels eines Computers simulierte integrierte Schaltungen, umfassend
(a) das Bereitstellen einer ersten Datei (1), die eine integrierte Schaltung beschreibt;
(b) das Simulieren (4) einer mutierten integrierten Schaltung, die durch Einbau von Mutationen in die in der ersten Datei beschriebene integrierte Schaltung erhalten wird, wobei jeweils nur eine der Mutationen aktiv geschaltet ist, während die anderen Mutationen inaktiviert sind und wobei die Mutationen nacheinander aktiv geschaltet werden, und unter Zuführung von Eingangswerten zu der mutierten integrierten Schaltung und Erfassen der für diese Eingangswerte von der mutierten integrierten Schaltung erzeugten Ausgangswerte;
(c) den Vergleich (6) der von der mutierten integrierten Schaltung erzeugten Ausgangswerte mit Erwartungswerten, die von dem Testprogramm bereitgestellt werden, wobei die Erwartungswerte in einem von der in der ersten Datei (1) beschriebenen integrierten Schaltung unabhängigen Referenzsystem (5) generiert worden sind; und
(d) die Bewertung der Güte (7) des Testprogramms anhand der Vergleichsergebnisse.

2. Verfahren nach Anspruch 1, **dadurch gekennzeichnet, daß** Schritt (b) folgende Schritte umfaßt:
(b1) das Erzeugen einer zweiten Datei, die die mutierte integrierte Schaltung beschreibt, aus der ersten Datei durch den Einbau der Mutationen in die erste Datei; und
(b2) das Simulieren der mutierten integrierten Schaltung.

3. Verfahren nach Anspruch 1, **dadurch gekennzeichnet, daß** Schritt (b) folgende Schritte umfaßt:
(b1) das Einlesen der ersten Datei in das Simulationsprogramm des Computers;
(b2) das Abbilden der in der ersten Datei beschriebenen integrierten Schaltung in der Simulationseinheit;
(b3) den Einbau der Mutationen in die in der Simulationseinheit abgebildete integrierte Schaltung, wodurch die mutierte integrierte Schaltung erhalten wird; und
(b4) das Simulieren der mutierten integrierten Schaltung.

4. Verfahren nach einem der vorstehenden Ansprüche, **dadurch gekennzeichnet, daß** die erste Datei aus einer Vielzahl von Unterdateien besteht, die zusammen die integrierte mutierte Schaltung beschreiben.

5. Verfahren nach einem der vorstehenden Ansprüche, **dadurch gekennzeichnet, daß** der Einbau der Mutationen in die integrierte Schaltung folgende Schritte umfaßt:
(i) Analyse der ersten Datei, um die Stellen in der ersten Datei aufzufinden, an denen Mutationen eingebaut werden können, und für jede aufgefundene Stelle den Typ der Mutation zu bestimmen, der an dieser Stelle eine Änderung des Verhaltens der integrierten Schaltung bewirkt;
(ii) Analyse der Tests, die das Testprogramm ausführen kann, um die Tests auszuwählen, die Eingangswerte bereitstellen, die eine Mutation ansprechen können; und
(iii) Auswahl der Mutationen, die an einer gemäß Schritt (i) aufgefundenen Stelle eine Änderung des Verhaltens der integrierten Schaltung bewirken und die durch einen der Tests angesprochen werden können, und Erzeugen der mutierten integrierten Schaltung.

6. Verfahren nach Anspruch 5, **dadurch gekennzeichnet, daß** es ferner das Zusammenstellen der Tests, die eine der ausgewählten Mutation zumindest einmal ansprechen können, zu einem Testset umfaßt.

7. Verfahren nach einem der vorstehenden Ansprüche, **dadurch gekennzeichnet, daß** das Ergebnis des Vergleiches negativ ist, wenn der für eine Mutation erhaltene Ausgangswert dem für den Ausgangswert generierten Erwartungswert gleicht.

8. Verfahren nach einem der vorstehenden Ansprüche, **dadurch gekennzeichnet, daß** das Ergebnis des Vergleiches positiv ist, wenn der für eine Mutation erhaltene Ausgangswert ungleich dem für den Ausgangswert generierten Erwartungswert ist.

9. Verfahren nach einem der vorstehenden Ansprüche, **dadurch gekennzeichnet, daß** die Güte des Testprogramms aus dem Verhältnis der Anzahl der positiven Vergleichsergebnisse zur Anzahl der negativen Vergleichsergebnisse ermittelt wird.

10. Verfahren nach einem der vorstehenden Ansprüche, **dadurch gekennzeichnet, daß** die Güte des Testprogramms mit gut bewertet wird, wenn für jede eingebaute Mutation ein positives Vergleichsergebnis erhalten wird.

11. Verfahren nach einem der Ansprüche 1 bis 9, **dadurch gekennzeichnet, daß** die Güte des Testprogramms mit gut bewertet wird, wenn die Anzahl der Mutationen, für die ein positives Vergleichsergebnis erhalten wird, einen vorgegebenen Wert übersteigt.

12. Verfahren nach einem der vorstehenden Ansprüche, **dadurch gekennzeichnet, daß**, wenn das Ergebnis des Vergleiches für eine Mutation negativ ist, der Erwartungswert für diese Mutation verändert wird und anschließend die Schritte (b) bis (d) wiederholt werden.

13. Verfahren nach einem der Ansprüche 1 bis 11, **dadurch gekennzeichnet, daß**, wenn das Ergebnis des Vergleiches für eine Mutation negativ ist, die erste Datei verändert wird und anschließend die Schritte (b) bis (d) wiederholt werden.

14. Verfahren nach einem der Ansprüche 1 bis 11, **dadurch gekennzeichnet, daß**, wenn das Ergebnis des Vergleiches für eine Mutation negativ ist, Tests ausgewählt werden, die diese Mutation ansprechen und gegenüber den bisherigen Tests veränderte Eingangswerte bereitstellen, und anschließend die Schritte (b) bis (d) wiederholt werden.

15. Verfahren nach einem der vorstehenden Ansprüche, **dadurch gekennzeichnet, daß** die mutierte integrierte Schaltung mittels eines Hardwarebeschleunigers realisiert wird.

## Claims

1. A computer implemented method for rating the quality of a test program for integrated circuits simulated by means of a computer, comprising
(a) provision of a first file (1) which describes an integrated circuit;
(b) simulation (4) of a mutated integrated circuit which is obtained by incorporating mutations into the integrated circuit described in the first file, wherein there is only one of the mutations activated whereas the other mutations are inactivated and whererin the mutations are activated sequentially, and during supply of input values to the mutated integrated circuit and recording of the output values produced for these input values by the mutated integrated circuit;
(c) comparison (6) of the output values produced by the mutated integrated circuit with expected values which are provided by the test program, where the expected values have been generated in a reference system (5) that ist independent from the integrated circuit descreibed in the first file (1); and
(d) rating of the quality (7) of the test program on the basis of the comparison results.

2. The method as claimed in claim 1, wherein step (b) comprises the following steps:
(b1) production of a second file which describes the mutated integrated circuit from the first file by incorporating the mutations into the first file; and
(b2) simulation of the mutated integrated circuit.

3. The method as claimed in claim 1, wherein step (b) comprises the following steps:
(b1) reading of the first file into the simulation program of the computer;
(b2) mapping of the integrated circuit described in the first file in the simulation unit;
(b3) incorporation of the mutations into the integrated circuit mapped in the simulation unit, which gives the mutated integrated circuit; and
(b4) simulation of the mutated integrated circuit.

4. The method as claimed in one of the preceding claims, wherein the first file comprises a multiplicity of subfiles which together describe the integrated mutated circuit.

5. The method as claimed in one of the preceding claims, **characterized in that** incorporation of the mutations into the integrated circuit comprises the following steps:
(i) analysis of the first file in order to find the locations in the first file at which mutations can be incorporated and to determine, for each location found, the type of mutation which brings about a change in the behavior of the integrated circuit at this location;
(ii) analysis of the tests which the test program is able to execute in order to select the tests which provide input values which can address a mutation; and
(iii) selection of the mutations which bring about a change in the behavior of the integrated circuit at a location found in accordance with step (i) and which can be addressed by one of the tests, and production of the mutated integrated circuit.

6. The method as claimed in claim 5, wherein it also comprises compilation of the tests which can address one of the selected mutations at least once to form a test set.

7. The method as claimed in one of the preceding claims, wherein the result of the comparison is negative if the output value obtained for a mutation equates to the expected value generated for the output value.

8. The method as claimed in one of the preceding claims, wherein the result of the comparison is positive if the output value obtained for a mutation is not equal to the expected value generated for the output value.

9. The method as claimed in one of the preceding claims, wherein the quality of the test program is ascertained from the ratio of the number of positive comparison results to the number of negative comparison results.

10. The method as claimed in one of the preceding claims, wherein the quality of the test program is rated as good if a positive comparison result is obtained for each incorporated mutation.

11. The method as claimed in one of claims 1 to 9, wherein the quality of the test program is rated as good if the number of mutations for which a positive comparison result is obtained exceeds a prescribed value.

12. The method as claimed in one of the preceding claims, wherein if the result of the comparison for a mutation is negative then the expected value for this mutation is altered and then steps (b) to (d) are repeated.

13. The method as claimed in one of claims 1 to 11, wherein if the result of the comparison for a mutation is negative then the first file is altered and then steps (b) to (d) are repeated.

14. The method as claimed in one of claims 1 to 11, wherein if the result of the comparison for a mutation is negative then tests are selected which address this mutation and provide altered input values in comparison with the previous tests, and then steps (b) to (e) are repeated.

15. The method as claimed in one of the preceding claims, wherein the mutated integrated circuit is implemented using a hardware accelerator.

## Revendications

1. Procédé mis en oeuvre par ordinateur d'évaluation de la qualité d'un programme-test pour commandes intégrées simulées à l'aide d'un ordinateur comprenant
(a) la mise à disposition d'un premier fichier (1) décrivant une commande intégrée ;
(b) la simulation (4) d'une commande intégrée mutée qui est obtenue par l'incorporation de mutations dans la commande intégrée décrite dans le premier fichier, respectivement une seule des mutations étant activée alors que les autres mutations sont désactivées et les mutations s'activant les unes après les autres et avec alimentation de valeurs d'entrée à la commande intégrée mutée et saisie des valeurs de sortie générées pour cette valeur d'entrée par la commande intégrée mutée ;
(c) la comparaison (6) des valeurs de sortie générées par la commande intégrée mutée avec les valeurs escomptées mises à la disposition par le programme-test, les valeurs escomptées étant générées dans un système référence (5) indépendant de la commande intégrée décrite dans le premier fichier (1) et
(d) l'évaluation de la qualité (7) du programme-test à l'aide des résultats de comparaison.

2. Procédé selon la revendication 1 **caractérisé en ce que** l'opération (b) comprend les opérations suivantes :
(b1) la génération d'un deuxième fichier, décrivant la commande intégrée mutée, à partir du premier fichier par l'incorporation des mutations et
(b2) la simulation de la commande intégrée mutée.

3. Procédé selon la revendication 1 **caractérisé en ce que** l'opération (b) comprend les opérations suivantes :
(b1) la lecture du premier fichier dans le programme de simulation de l'ordinateur ;
(b2) la représentation de la commande intégrée mutée décrite dans le premier fichier dans l'unité de simulation ;
(b3) l'incorporation des mutations dans la commande intégrée illustrée dans l'unité de simulation, la commande intégrée mutée étant obtenue et
(b4) la simulation de la commande intégrée mutée.

4. Procédé selon l'une des revendications précédentes **caractérisé en ce que** le premier fichier se compose d'une quantité de sous-fichiers qui ensemble décrivent la commande intégrée mutée.

5. Procédé selon l'une des revendications précédentes **caractérisé en ce que** l'incorporation des mutations dans la commande intégrée comprend les opérations suivantes :
(i) analyse du premier fichier pour trouver les points dans le premier fichier auxquels les mutations peuvent être incorporées et pour chaque points trouvés de déterminer le type de la mutation provoquant une modification du comportement de la commande intégrée ;
(ii) analyse des tests pouvant effectuer le programme-test pour sélectionner les tests mettant à disposition les valeurs d'entrée susceptibles de déclencher une mutation ; et
(iii) sélection des mutations qui, à un point trouvé conformément à l'opération (i), provoquent une modification du comportement de la commande intégrée et pouvant être activée par un des tests et génération de la commande intégrée mutée.

6. Procédé selon la revendication 5 **caractérisé en ce qu'**il comprend en plus le regroupement en un groupe de tests des tests pouvant déclencher au moins une fois une des mutations sélectionnées.

7. Procédé selon l'une des revendications précédentes **caractérisé en ce que** le résultat de la comparaison est négatif si la valeur de sortie obtenue pour une mutation est identique à la valeur escomptée générée pour la valeur de sortie.

8. Procédé selon l'une des revendications précédentes **caractérisé en ce que** le résultat de la comparaison est positif si la valeur de sortie obtenue pour une mutation est différente à la valeur escomptée générée pour la valeur de sortie.

9. Procédé selon l'une des revendications précédentes **caractérisé en ce que** la qualité du programme-test déterminée à partir du rapport du nombre des résultats comparatifs positifs et du nombre des résultats comparatifs négatifs.

10. Procédé selon l'une des revendications précédentes **caractérisé en ce que** la qualité du programme-test est évaluée comme bonne si pour chaque mutation incorporée, on obtient un résultat comparatif positif.

11. Procédé selon d'une des revendications 1 à 9 **caractérisé en ce que** la qualité du programme-test est évaluée comme bonne si le nombre de mutations pour lesquelles un résultat comparatif positif est obtenu dépasse une valeur prédéfinie.

12. Procédé selon l'une des revendications précédentes **caractérisé en ce que** si le résultat de la comparaison pour une mutation est négatif, la valeur escomptée est modifiée pour cette mutation et ensuite les opérations (b) à (d) sont répétées.

13. Procédé selon l'une des revendications 1 à 11 **caractérisé en ce que** si le résultat de la comparaison pour une mutation est négatif, le premier fichier est modifié et ensuite les opérations (b) à (d) sont répétées.

14. Procédé selon l'une des revendications 1 à 11 **caractérisé en ce que** si le résultat de la comparaison pour une mutation est négatif, des tests sont sélectionnés déclenchant cette mutation et par rapport à des tests effectués jusqu'à maintenant, mettant des valeurs d'entrée modifiées et ensuite les opérations (b) à (d) sont répétées.

15. Procédé selon l'une des revendications précédentes **caractérisé en ce que** la commande intégrée mutée est réalisée à l'aide d'un accélérateur de matériel.
